# EUROPEAN PATENT SPECIFICATION

(11) **EP 4 006 404 B1**
(45) Date of publication and mention of the grant of the patent: **31.12.2025**
(21) Application number: 20858167.8
(22) Date of filing: 28.08.2020
(51) Int. Cl.: F21S 2/00

(54) **LIGHT SOURCE SYSTEM AND ILLUMINATION APPARATUS**
LICHTQUELLENSYSTEM UND BELEUCHTUNGSVORRICHTUNG
SYSTÈME DE SOURCE DE LUMIÈRE ET APPAREIL D'ÉCLAIRAGE

(30) Priority: 30.08.2019 CN 201910814234
(43) Date of publication of application: 01.06.2022
(73) Proprietor: YLX Incorporated, Shenzhen, Guangdong 518000 (CN)
(72) Inventor: LI, Qian, Shenzhen, Guangdong 518000 (CN); CHEN, Yusan, Shenzhen, Guangdong 518000 (CN); WANG, Yangang, Shenzhen, Guangdong 518000 (CN)
(74) Representative: Luppi Intellectual Property S.r.l.
(86) International application number: PCT/CN2020/112197
(87) International publication number: WO 2021/037225

(56) References cited:
- WO-A1-2017/038176
- CN-A- 107 575 830
- CN-A- 109 884 850
- CN-A- 110 095 928
- CN-U- 204 986 566
- CN-U- 207 880 586
- CN-U- 207 880 586
- US-A1- 2019 024 854
- US-A1- 2019 137 061

## Description

### TECHNICAL FIELD

The present disclosure relates to the field of optical technology, in particular to a light source system and an illumination apparatus applying the light source system.

### BACKGROUND

In the lighting field of laser-activated remote phosphor technology, a blue laser is usually configured to excite a yellow fluorescent material layer to produce yellow fluorescence, and the yellow fluorescence is combined with the blue laser to produce white light. A "spot diffusion phenomenon" occurs when the laser beams are gathered to form an emission spot to irradiate a surface of the fluorescent material layer, that is, the phenomenon that an area A' of emission spot after excitation is larger than an actual area A of an excitation light spot. In the field of lighting applications, such a diffusion phenomenon will cause a problem of "yellow ring" on an edge of a light spot formed by the finally projected white light beams, which seriously affects the color uniformity of the light spot.

At present, light-homogenizing optical elements such as fly-eye lenses or square rods are usually used as assistance to shape and homogenize the emitted white light spot, so that the color of the projected white light is uniform. However, the introduction of components such as a fly-eye lens or a square rod makes the design of the light path complicated, which not only increases the volume and cost of the light source, but also reduces the light collection efficiency of the light source. Relevant documents in the art include CN 207880586 U, US 2019/024854 Al, US 2019/137061 Al.

### SUMMARY

An aspect of the present disclosure provides a light source system. The light source system includes a first excitation light source configured to emit a first excitation light, a wavelength conversion structure, and a second excitation light source. The wavelength conversion structure includes a wavelength conversion material layer, the wavelength conversion material layer is configured to receive the first excitation light and convert at least part of the first excitation light into a first excited light and then emit the first excited light. The wavelength conversion material layer has a surface opposite to an incident surface of the first excitation light, and the surface is defined with a transmission area and a non-transmission area surrounded by the transmission area. The second excitation light source is arranged at a side of the wavelength conversion structure away from the incident surface of the first excitation light, the second excitation light source is configured to emit a second excitation light, and the second excitation light is incident to the wavelength conversion material layer from the transmission area. The wavelength conversion material layer converts at least part of the second excitation light into the second excited light and then emits the second excited light, and transmits part of the second excitation light that is not absorbed by the wavelength conversion material layer.

Another aspect provides an illumination apparatus including the above light source system.

In the light source system provided in the embodiment, the first excitation light source and the second excitation light source are arranged at two sides of the wavelength conversion material layer, respectively, and the non-transmission area and the transmission area surrounding the non-transmission area are provided on the surface of the wavelength conversion material layer, and said surface is close to the second excitation light source, so that the second excitation light emitted by the second excitation light source is only incident to the wavelength conversion material layer from the transmission area, that is, the second excitation light is only incident from the edge area of the wavelength conversion material layer, and part of the second excitation light is converted to the second excited light by the wavelength conversion material layer. The unconverted second excitation light and the converted second excited light are emitted from the edge area of the surface of the wavelength conversion material layer away from the second excitation light source, which makes up the deficiency of insufficient laser in the edge area, facilitates to improve the halo caused by the first excitation light source, and improves the color uniformity of light source light emitted by the light source system.

### BRIEF DESCRIPTION OF DRAWINGS

FIG. 1 is a schematic diagram of a light source system provided by an embodiment of the present disclosure.
FIG. 2 is a schematic diagram of a wavelength conversion structure provided by an embodiment of the present disclosure.
FIG. 3 illustrates side views of a wavelength conversion material layer and a reflective layer that are shown in FIG. 2.
FIG. 4 is a top view of a wavelength conversion material layer shown in FIG. 2. Symbol description for main components

| | |
|---|---|
| Light source system | 10 |
| First excitation light source | 11 |
| Second excitation light source | 12 |
| Sub strate | 121 |
| Light emitting device | 122 |
| Wire | 123 |
| Wavelength conversion structure | 13 |
| Wavelength conversion material layer | 131 |
| Reflective layer | 132 |
| Transparent adhesive material layer | 133 |
| Transmission area | A |
| Non-transmission area | B |
| Light guide element | 14 |
| Central area | 141 |
| Peripheral area | 142 |
| First lens | 15 |
| Second lens | 16 |

### DESCRIPTION OF EMBODIMENTS

The following will describe the embodiments of the present disclosure in conjunction with the above drawings.

### First embodiment

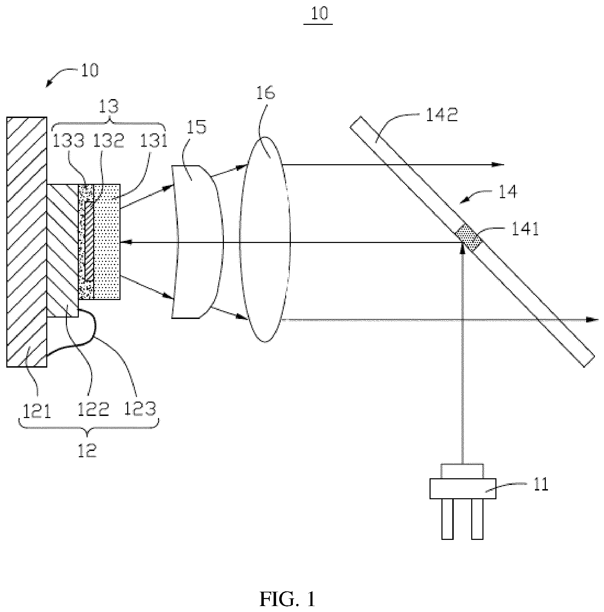

Referring to FIG. 1, a light source system 10 provided by the present embodiment includes a first excitation light source 11, a second excitation light source 12, and a wavelength conversion structure 13. The first excitation light source 11 and the second excitation light source 12 are located at two sides of the wavelength conversion structure 13, respectively.

The first excitation light source 11 is configured to emit the first excitation light. In the embodiment, the first excitation light source 11 is a laser or a laser array, that is, the first excitation light is a laser.

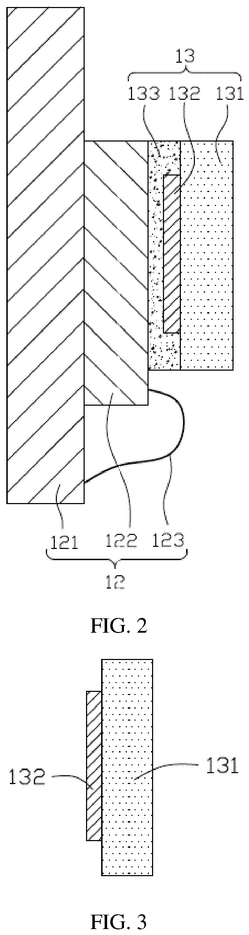

Referring to FIG. 2, the second excitation light source 12 includes a substrate 121, a light emitting device 122 disposed between the substrate 121 and the wavelength conversion structure 13, and a wire 123 electrically connected to both the substrate 121 and the light emitting device 122.

The substrate 121 is configured to carry the light emitting device 122. In the embodiment, the substrate 121 is a copper sheet with a smooth surface. In other embodiments, the substrate 121 can also be made of other materials, such as aluminum, A1N ceramics, etc. The present disclosure does not limit the material of the substrate 121. The light emitting device 122 is configured to emit second excitation light. In the embodiment, the light emitting device 122 is a light-emitting diode (LED) chip for emitting blue light with a wavelength ranging from 440 nm to 445 nm (i.e., the second excitation light). In other embodiments, the light emitting device 122 is an LED chip group including multiple LED chips arranged in an array, and the multiple LED chips emit the second excitation light with the same color. The light emitting device 122 includes an electrode (not shown in figures), and the wire 123 is configured to electrically connect the electrode of the light-emitting device 122 to the substrate 121. In the embodiment, the wire 123 is a gold wire.

Referring to FIG. 2 again, the wavelength conversion structure 13 includes a wavelength conversion material layer 131. The wavelength conversion material layer 131 is configured to receive the first excitation light emitted by the first excitation light source 11 and convert at least part of the first excitation light to first excited light and then emit the first excited light. In the embodiment, the wavelength conversion material layer 131 is a fluorescent ceramic layer, and when receiving the first excitation light, the wavelength conversion material layer 131 is configured to convert at least part of the first excitation light to fluorescence and then emit the fluorescence. In the embodiment, the first excitation light is a blue laser, and the fluorescent ceramic layer contains a yellow fluorescent substance. The yellow fluorescent substance is excited to emit yellow fluorescence when receiving the blue laser, and the yellow fluorescence has a wavelength ranging from 460 nm to 700 nm.

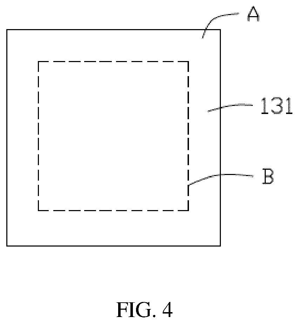

Referring to FIG. 3 and FIG. 4, a surface of the wavelength conversion material layer 131 opposite to an incident surface of the first excitation light defines a transmission area A and a non-transmission area B surrounded by the transmission area A. The second excitation light emitted by the light emitting device 122 can be incident to the wavelength conversion material layer 131 from the transmission area A, and the wavelength conversion material layer 131 converts at least part of the incident second excitation light to the second excited light and then emits the second excited light while the wavelength conversion material layer 131 transmits part of the second excitation light that is not converted.

A reflective layer 132 is provided in the non-transmission area B, and the reflective layer 132 is configured to block the second excitation light from entering the wavelength conversion material layer 131 from the non-transmission area B, and to reflect part of the second excitation light that is not absorbed by the wavelength conversion material layer 131. Specifically, the reflective layer 132 can be formed by, but not limited to, the following two methods.

In a first method, a diffuse reflective layer is formed, which includes mixing at least one of white reflective alumina powder, titanium dioxide, zirconium oxide, magnesium oxide, and zinc oxide with silica gel and then dispensing the mixture on a surface of the fluorescent ceramic and then perform curing. Or, the magnetron sputtering is used, and a mask is utilized to achieve regional plating of metal oxide reflective layers, such as aluminum oxide, titanium oxide, silicon oxide, calcium oxide, etc. The diffuse reflective layer can have a shape of square, circle, or regular polygon, etc.

In a second method, magnetron sputtering or vacuum evaporation method is used to realize the regional coating layer in the non-transmission area B with a mask. The above layer is a metal layer with light reflection effect, such as silver, aluminum, etc. The layer has a shape of square, circle, or regular polygon, etc.

In the embodiment, the reflective layer 132 is a thin coating layer, which is beneficial to release energy (in the embodiment, it mainly refers to the light energy generated by the second excitation light source 12), thereby avoiding the accumulated energy to be converted to produce heat and increase the temperature, and reducing work efficiency of the wavelength conversion structure 13.

In the embodiment, the surface of the wavelength conversion material layer 131 close to the second excitation light source 12 has a shape of rectangle, the non-transmission area B is located in a central area of the rectangle and also has a shape of rectangle, and the transmission area A is located in the edge area surrounding the non-transmission area B. In other embodiments, the surface of the wavelength conversion material layer 131 close to the second excitation light source 12 can have other shapes, and the shape of the non-transmission area B is not necessarily the same as the shape of the surface of the wavelength conversion material layer 131 close to the second excitation light source 12. However, preferably, the non-transmission area B is located in the central area of the surface of the wavelength conversion material layer 131 close to the second excitation light source 12, and the reflective layer 132 is disposed in the central area of the surface of the wavelength conversion material layer 131 facing towards the second excitation light source 12.

The second excited light and the unconverted part of the second excitation light are jointly emitted from a surface of the wavelength conversion material layer 131 away from the second excitation light source 12. In the embodiment, the second excited light is fluorescent, the LED chip emits blue light (that is, the second excitation light is blue light), the wavelength conversion material layer 131 is a yellow fluorescent material, and the blue second excitation light excites the fluorescent material to generate yellow fluorescence with a wavelength ranging from 460 nm to 700 nm.

Further, in the embodiment, the wavelength conversion structure 13 includes a transparent adhesive material layer 133 disposed between the second excitation light source 12 and the wavelength conversion material layer 131 and the transparent adhesive material layer 133 is configured to bond the light emitting device 122 and the wavelength conversion material layer 131 and bond the light emitting device 122 and the reflective layer 132. The transparent adhesive material layer 133 includes silica gel. The silica gel uses a high refractive index silicone glue with a refractive index of 1.51, so that transmittance of light (blue light) with a wavelength ranging from 420 nm to 460 nm is greater than 95%. The silica gel has higher heat resistance, and the specific heat resistance requirement is that the silica gel can maintain a continuous and stable operation for a period longer than a preset time in a working environment within 200°C. The preset time is determined according to the actual application scenario of the wavelength conversion structure 13. In the manufacturing process of the wavelength conversion structure 13, the transparent adhesive material layer 133 can be coated on the surface of the light emitting device 122 first, and then the wavelength conversion material layer 131 is adhered to the transparent adhesive material layer 133.

Referring to FIG. 1 again, the light source system 10 further includes a light guide element 14. In the embodiment, the light guide element 14 is a regional coating film. The light guide element 14 is arranged on a propagation path of the first excitation light emitted by the first excitation light source 11, and is configured to guide the first excitation light emitted by the first excitation light source 11 to the wavelength conversion structure 13, specifically, is configured to guide the first excitation light emitted by the first excitation light source 11 to a side of the wavelength conversion material layer 131 away from the second excitation light source 12.

Further, the light guide element 14 includes a central area 141 and a peripheral area 142 surrounding the central area 141, and the central area 141 is a dichroic area. When the first excitation light source 11 is turned on, the first excitation light is incident to the central area 141 and is reflected by the dichroic area to the wavelength conversion material layer 131. The first excitation light is partially absorbed by the wavelength conversion material layer 131 to excite the fluorescent substance in the wavelength conversion material layer 131 to generate fluorescence, and the combined light of the unabsorbed part of the first excitation light and the generated fluorescence is emitted from the wavelength conversion material layer 131 and then transmitted from the peripheral area 142 of the light guide element 14.

Referring to FIG. 1 again, the light source system 10 further includes a collecting lens disposed between the wavelength conversion structure 13 and the light guide element 14, and the collecting lens includes a first lens 15 and a second lens 16. The first lens 15 and the second lens 16 are both condensing lenses. The first lens 15 and the second lens 16 are jointly configured to condense light emitted from the wavelength conversion structure 13 in divergent propagation directions to parallel light beams to enter the light guide element 14. In other embodiments, the collecting lens can include only the first lens 15. In another embodiment, the collecting lens can also include a third lens, a fourth lens and more structures that are configured to condense light.

The working mode of the light source system 10 provided in the embodiment is described in the following.

The first excitation light source 11 is turned on, the first excitation light source 11 emits the first excitation light, the first excitation light is incident to the central area 141 of the light guide element 14, and the central area 141 reflects the first excitation light to the wavelength conversion material layer 131, part of the first excitation light is absorbed by the wavelength conversion material layer 131 and is incident from the surface of the wavelength conversion material layer 131 away from the second excitation light source 12, so as to excite the fluorescent substance in the wavelength conversion material layer 131 to convert the first excitation light into the first excited light. The generated first excited light is emitted from the surface of the wavelength conversion material layer 131 away from the second excitation light source 12, and part of the unabsorbed first excitation light is reflected by the surface of the wavelength conversion material layer 131 away from the second excitation light source 12. The combined light of the first excited light and part of the unconverted first excitation light is emitted from the surface of the wavelength conversion material layer 131 away from the second excitation light source 12. In the embodiment, the first excitation light is blue laser with a wavelength of 445 nm, and the first excited light is a yellow fluorescence with a wavelength ranging from 460 nm and 700 nm.

Since the first excitation light is laser light, when it is incident to the wavelength conversion material layer 131, a laser light spot is generated. The intensity distribution law of the laser light spot is as follows: the intensity of the laser light spot is higher in the middle and gradually reduces toward the outside. As a result, there is more laser in the middle area of the light spot and less laser in the edge area, so that the edge area of the combined light of the first excited light emitted from the wavelength conversion material layer 131 and part of the unconverted first excitation light will have a halo with the same color as the first excited light. In the embodiment, the first excitation light is a blue laser, and the first excited light is yellow fluorescence. The combined light of the yellow fluorescence and the unconverted blue laser is white light, and a yellow halo occurs in the edge area of the white light, resulting in that the combined light of the yellow fluorescence and the unconverted blue laser has a poor overall color uniformity.

Therefore, in the light source system 10 of the embodiment, in order to eliminate the halo, when the first excitation light source 11 is turned on, the second excitation light source 12 can be turned on, that is, the light emitting device 122 is turned on, and the light emitting device 122 emits the second excitation light, the second excitation light is incident from the surface of the wavelength conversion material layer 131 away from the first excitation light source 11. Specifically, the surface of the wavelength conversion material layer 131 away from the first excitation light source 11 defines a non-transmission area B located in the central area and a transmission area A located in the edge area and surrounding the non-transmission area B. The reflective layer 132 is provided in the non-transmission area B. When the second excitation light is incident to the non-transmission area B, the second excitation light is blocked and reflected by the reflective layer 132 and cannot enter the wavelength conversion material layer 131. When the second excitation light is incident to the transmission area A, the second excitation light is incident from the edge area of the wavelength conversion material layer 131, part of the incident second excitation light excites the fluorescent substance in the wavelength conversion material layer 131 to generate the second excited light, and part of the unconverted second excitation light is emitted from the edge area of the surface of the wavelength conversion material layer 131 away from the second excitation light source 12. In the embodiment, the second excitation light is blue light with a wavelength ranging from 440 nm to 445 nm, and the second excited light is yellow fluorescence with a wavelength ranging from 460 nm to 700 nm.

Since the unconverted second excitation light is emitted from the edge area of the surface of the wavelength conversion material layer 131 away from the second excitation light source 12, the defect that there is insufficient laser in the edge area of the combined light of the first excited light and part of the unconverted first excitation light is remedied, which is conducive to solving the problem of having halo in the edge area of the combined light of the first excited light and part of the unconverted first excitation light.

The combined light of the first excited light, the second excited light, part of the unconverted first excitation light, and part of the unconverted second excitation light is emitted from the surface of the wavelength conversion material layer 131 away from the second excitation light source 12 as the light source light. In the embodiment, the light source light has white color, and forms parallel light beams through the condensing function of the first lens 15 and the second lens 16, and then is transmitted from the peripheral area 142 of the light guide element 14.

In the light source system 10 provided by the embodiment, the first excitation light source 11 and the second excitation light source 12 are arranged at two sides of the wavelength conversion material layer 131, respectively, and the non-transmission area B and the transmission area A surrounding the non-transmission area B are provided on the surface of the wavelength conversion material layer, and said surface is close to the second excitation light source 12, so that the second excitation light emitted by the second excitation light source 12 is only incident to the wavelength conversion material layer 131 from the transmission area A, that is, the second excitation light is only incident from the edge area of the wavelength conversion material layer 131, and part of the second excitation light is converted to the second excited light by the wavelength conversion material layer 131. The unconverted second excitation light and the converted second excited light are emitted from the edge area of the surface of the wavelength conversion material layer 131 away from the second excitation light source 12, which corrects the defect of insufficient laser in the edge area, facilitates to improve the halo caused by the first excitation light source 11, and improves the color uniformity of the light source light emitted by the light source system 10.

The present disclosure also provides an illumination apparatus including the above light source system 10.

It should be understood that the illumination apparatus in the embodiment can achieve all the beneficial effects described above.

## Claims

1. A light source system (10), comprising:
a first excitation light source (11), configured to emit a first excitation light;
a wavelength conversion structure (13), comprising a wavelength conversion material layer (131) configured to receive the first excitation light and convert at least part of the first excitation light into a first excited light and then emit the first excited light; wherein the wavelength conversion material layer (131) has a surface opposite to an incident surface of the first excitation light, and the surface of the wavelength conversion material layer (131) has a transmission area and a non-transmission area surrounded by the transmission area; and
a second excitation light source (12) arranged at a side of the wavelength conversion structure (13) away from the incident surface of the first excitation light, wherein the second excitation light source (12) is configured to emit a second excitation light, and the second excitation light is incident to the wavelength conversion material layer (131) from the transmission area; and the wavelength conversion material layer (131) is configured to convert at least part of the second excitation light into a second excited light and then emits the second excited light, and transmits part of the second excitation light that is not absorbed by the wavelength conversion material layer (131).

2. The light source system (10) according to claim 1, wherein the second excitation light source (12) comprises:
a substrate (121);
a light emitting device (122) arranged between the substrate (121) and the wavelength conversion structure (13) and configured to emit the second excitation light; and
a wire (123) electrically connected to both the substrate (121) and the light-emitting device.

3. The light source system (10) according to claim 2, wherein the light emitting device (122) is an LED chip for emitting blue light with a wavelength ranging from 440 nm to 445 nm or an LED chip group including multiple LED chips arranged in an array, emitting blue light with a wavelength ranging from 440 nm to 445 nm.

4. The light source system (10) according to any one of claim 1-3, wherein the first excitation light source (11) is a laser or a laser array.

5. The light source system (10) according to any one of claim 1-4, wherein the first excitation light is blue laser with a wavelength of 445 nm, and the first excited light is a yellow fluorescence with a wavelength ranging from 460 nm and 700 nm.

6. The light source system (10) according to any one of claim 1-5, wherein the second excitation light is blue light with a wavelength ranging from 440 nm to 445 nm, and the second excited light is yellow fluorescence with a wavelength ranging from 460 nm to 700 nm.

7. The light source system (10) according to any one of claim 1-6, wherein a reflective layer (132) is provided in the non-transmission area, and the reflective layer (132) is configured to block the second excitation light from entering the wavelength conversion material layer (131) from the non-transmission area, and is further configured to reflect part of the first excitation light that is not absorbed by the wavelength conversion material layer (131).

8. The light source system (10) according to claim 7, wherein the reflective layer (132) is a diffuse reflective layer.

9. The light source system (10) according to claim 7, wherein the reflective layer (132) is a metal reflective layer.

10. The light source system (10) according to any one of claim 1-9, wherein the wavelength conversion structure (13) further comprises a transparent adhesive material layer (133) disposed between the second excitation light source (12) and the wavelength conversion material layer (131).

11. The light source system (10) according to claim 10, wherein the transparent adhesive material layer (133) comprises silica gel which uses silicone glue with a refractive index of 1.51, such that transmittance of light with a wavelength ranging from 420 nm to 460 nm is greater than 95%.

12. The light source system (10) according to any one of claim 1-11, further comprising:
a light guide element (14) arranged in an optical path between the first excitation light source (11) and the wavelength conversion structure (13),
wherein the light guide element (14) has a central area and a peripheral area surrounding the central area, the central area is configured to reflect the first excitation light emitted by the first excitation light source (11), such that the first excitation light is incident to the wavelength conversion material layer (131), and the peripheral area is a transmission area.

13. The light source system (10) according to claim 12, wherein the light guide element (14) is a regional coating film, and the central area is a dichroic area.

14. The light source system (10) according to claim 12 or 13, further comprising:
a collecting lens located between the wavelength conversion structure (13) and the light guide element (14).

15. An illumination apparatus, comprising the light source system (10) according to any one of claims 1-14.

## Patentansprüche

1. Lichtquellensystem (10), umfassend:
eine erste Anregungslichtquelle (11), die konfiguriert ist, um ein erstes Anregungslicht zu emittieren;
eine Wellenlängenumwandlungsstruktur (13), umfassend eine Wellenlängenumwandlungsmaterialschicht (131), die konfiguriert ist, um das erste Anregungslicht aufzunehmen und mindestens einen Teil des ersten Anregungslichts in ein erstes angeregtes Licht umzuwandeln und dann das erste angeregte Licht zu emittieren; wobei die Wellenlängenumwandlungsmaterialschicht (131) eine Oberfläche gegenüber einer Einfallsoberfläche des ersten Anregungslichts aufweist, und die Oberfläche der Wellenlängenumwandlungsmaterialschicht (131) einen Transmissionsbereich und einen Nicht-Transmissionsbereich, der durch den Transmissionsbereich umgeben ist, aufweist;
und
eine zweite Anregungslichtquelle (12), die an einer Seite der Wellenlängenumwandlungsstruktur (13) weg von der Einfallsoberfläche des ersten Anregungslichts arrangiert ist, wobei die zweite Anregungslichtquelle (12) konfiguriert ist, um ein zweites Anregungslicht zu emittieren, und das zweite Anregungslicht von dem Transmissionsbereich auf die Wellenlängenumwandlungsmaterialschicht (131) einfällt; und die Wellenlängenumwandlungsmaterialschicht (131) konfiguriert, ist, um mindestens einen Teil des zweiten Anregungslichts in ein zweites angeregtes Licht umzuwandeln und dann das zweite angeregte Licht emittiert und einen Teil des zweiten Anregungslichts, der durch die Wellenlängenumwandlungsmaterialschicht (131) nicht absorbiert wird, transmittiert.

2. Lichtquellensystem (10) nach Anspruch 1, wobei die zweite Anregungslichtquelle (12) umfasst:
ein Substrat (121);
eine lichtemittierende Vorrichtung (122), die zwischen dem Substrat (121) und der Wellenlängenumwandlungsstruktur (13) arrangiert und konfiguriert ist, um das zweite Anregungslicht zu emittieren; und
ein Draht (123), der sowohl mit dem Substrat (121) als auch mit der lichtemittierenden Vorrichtung elektrisch verbunden ist.

3. Lichtquellensystem (10) nach Anspruch 2, wobei die lichtemittierende Vorrichtung (122) ein LED-Chip zum Emittieren von Blaulicht mit einer Wellenlänge, die von 440 nm bis 445 nm reicht, oder eine LED-Chipgruppe, einschließlich mehrerer LED-Chips, die in einem Array arrangiert sind, ist, die blaues Licht mit einer Wellenlänge, die von 440 nm bis 445 nm reicht, emittieren.

4. Lichtquellensystem (10) nach einem der Ansprüche 1 bis 3, wobei die erste Anregungslichtquelle (11) ein Laser oder ein Laserarray ist.

5. Lichtquellensystem (10) nach einem der Ansprüche 1 bis 4, wobei das erste Anregungslicht ein blauer Laser mit einer Wellenlänge von 445 nm ist und das erste angeregte Licht eine gelbe Fluoreszenz mit einer Wellenlänge, die von 460 nm und 700 nm reicht, ist.

6. Lichtquellensystem (10) nach einem der Ansprüche 1 bis 5, wobei das zweite Anregungslicht Blaulicht mit einer Wellenlänge, die von 440 nm bis 445 nm reicht, ist und das zweite angeregte Licht die gelbe Fluoreszenz mit einer Wellenlänge, die von 460 nm bis 700 nm reicht, ist.

7. Lichtquellensystem (10) nach einem der Ansprüche 1 bis 6, wobei in dem Nicht-Transmissionsbereich eine reflektierende Schicht (132) bereitgestellt ist, und die reflektierende Schicht (132) konfiguriert ist, um ein Eindringen des zweiten Anregungslichts aus dem Nicht-Transmissionsbereich in die Wellenlängenumwandlungsmaterialschicht (131) zu blockieren, und ferner konfiguriert ist, um einen Teil des ersten Anregungslichts, der durch der Wellenlängenkonversionsmaterialschicht (131) nicht absorbiert wird, zu reflektieren.

8. Lichtquellensystem (10) nach Anspruch 7, wobei die reflektierende Schicht (132) eine diffuse reflektierende Schicht ist.

9. Lichtquellensystem (10) nach Anspruch 7, wobei die reflektierende Schicht (132) eine metallische reflektierende Schicht ist.

10. Lichtquellensystem (10) nach einem der Ansprüche 1 bis 9, wobei die Wellenlängenumwandlungsstruktur (13) ferner eine transparente Klebematerialschicht (133), die zwischen der zweiten Anregungslichtquelle (12) und der Wellenlängenumwandlungsmaterialschicht (131) angeordnet ist, umfasst.

11. Lichtquellensystem (10) nach Anspruch 10, wobei die transparente Klebematerialschicht (133) Silicagel, das Silikonkleber mit einem Brechungsindex von 1,51 verwendet, umfasst, derart, dass eine Lichtdurchlässigkeit mit einer Wellenlänge, die von 420 nm bis 460 nm reicht, über 95 % beträgt.

12. Lichtquellensystem (10) nach einem der Ansprüche 1 bis 11, ferner umfassend:
ein Lichtleiterelement (14), das in einem optischen Pfad zwischen der ersten Anregungslichtquelle (11) und der Wellenlängenumwandlungsstruktur (13) arrangiert ist,
wobei das Lichtleiterelement (14) einen zentralen Bereich und einen peripheren Bereich, der den zentralen Bereich umgibt, aufweist, wobei der zentrale Bereich konfiguriert ist, um das erste Anregungslicht, das durch die erste Anregungslichtquelle (11) emittiert wird, zu reflektieren, derart, dass das erste Anregungslicht auf die Wellenlängenumwandlungsmaterialschicht (131) einfällt, und der periphere Bereich ein Transmissionsbereich ist.

13. Lichtquellensystem (10) nach Anspruch 12, wobei das Lichtleiterelement (14) ein regionaler Deckfilm ist und der zentrale Bereich ein dichroitischer Bereich ist.

14. Lichtquellensystem (10) nach Anspruch 12 oder 13, ferner umfassend:
eine Sammellinse, die sich zwischen der Wellenlängenumwandlungsstruktur (13) und dem Lichtleiterelement (14) befindet.

15. Beleuchtungseinrichtung, umfassend das Lichtquellensystem (10) nach einem der Ansprüche 1 bis 14.

## Revendications

1. Système de source de lumière (10), comprenant:
une première source de lumière d'excitation (11), configurée pour émettre une première lumière d'excitation;
une structure de conversion de longueur d'onde (13), comprenant une couche de matériau de conversion de longueur d'onde (131) configurée pour recevoir la première lumière d'excitation et convertir au moins une partie de la première lumière d'excitation en une première lumière excitée, puis émettre la première lumière excitée; dans lequel la couche de matériau de conversion de longueur d'onde (131) a une surface opposée à une surface incidente de la première lumière d'excitation, et la surface de la couche de matériau de conversion de longueur d'onde (131) a une zone de transmission et une zone de non-transmission entourée par la zone de transmission; et
une seconde source de lumière d'excitation (12) disposée au niveau d'un côté de la structure de conversion de longueur d'onde (13) à distance de la surface incidente de la première lumière d'excitation, dans lequel la seconde source de lumière d'excitation (12) est configurée pour émettre une seconde lumière d'excitation, et la seconde lumière d'excitation est incidente sur la couche de matériau de conversion de longueur d'onde (131) à partir de la zone de transmission; et la couche de matériau de conversion de longueur d'onde (131) est configurée pour convertir au moins une partie de la seconde lumière d'excitation en une seconde lumière excitée, puis émet la seconde lumière excitée, et transmet une partie de la seconde lumière d'excitation qui n'est pas absorbée par la couche de matériau de conversion de longueur d'onde (131).

2. Système de source de lumière (10) selon la revendication 1, dans lequel la seconde source de lumière d'excitation (12) comprend:
un substrat (121);
un dispositif d'émission de lumière (122) disposé entre le substrat (121) et la structure de conversion de longueur d'onde (13) et configuré pour émettre la seconde lumière d'excitation; et
un fil (123) connecté électriquement à la fois au substrat (121) et au dispositif d'émission de lumière.

3. Système de source de lumière (10) selon la revendication 2, dans lequel le dispositif d'émission de lumière (122) est une puce à DEL pour l'émission d'une lumière bleue d'une longueur d'onde dans la plage de 440 nm à 445 nm ou un groupe de puces à DEL incluant de multiples puces à DEL disposées en réseau, émettant une lumière bleue d'une longueur d'onde dans la plage de 440 nm à 445 nm.

4. Système de source de lumière (10) selon l'une quelconque des revendications 1 à 3, dans lequel la première source de lumière d'excitation (11) est un laser ou un réseau de lasers.

5. Système de source de lumière (10) selon l'une quelconque des revendications 1 à 4, dans lequel la première lumière d'excitation est un laser bleu d'une longueur d'onde de 445 nm, et la première lumière excitée est une fluorescence jaune d'une longueur d'onde dans la plage de 460 nm à 700 nm.

6. Système de source de lumière (10) selon l'une quelconque des revendications 1 à 5, dans lequel la seconde lumière d'excitation est une lumière bleue d'une longueur d'onde dans la plage de 440 nm à 445 nm, et la seconde lumière excitée est une fluorescence jaune d'une longueur d'onde dans la plage de 460 nm à 700 nm.

7. Système de source de lumière (10) selon l'une quelconque des revendications 1 à 6, dans lequel une couche réfléchissante (132) est prévue dans la zone de non-transmission, et la couche réfléchissante (132) est configurée pour empêcher la seconde lumière d'excitation de pénétrer dans la couche de matériau de conversion de longueur d'onde (131) à partir de la zone de non-transmission, et est en outre configurée pour réfléchir une partie de la première lumière d'excitation qui n'est pas absorbée par la couche de matériau de conversion de longueur d'onde (131).

8. Système de source de lumière (10) selon la revendication 7, dans lequel la couche réfléchissante (132) est une couche réfléchissante diffuse.

9. Système de source de lumière (10) selon la revendication 7, dans lequel la couche réfléchissante (132) est une couche métallique réfléchissante.

10. Système de source de lumière (10) selon l'une quelconque des revendications 1 à 9, dans lequel la structure de conversion de longueur d'onde (13) comprend en outre une couche de matériau adhésif transparent (133) disposée entre la seconde source de lumière d'excitation (12) et la couche de matériau de conversion de longueur d'onde (131).

11. Système de source de lumière (10) selon la revendication 10, dans lequel la couche de matériau adhésif transparent (133) comprend un gel de silice qui utilise une colle de silicone avec un indice de réfraction de 1,51, de telle sorte que la transmittance de la lumière d'une longueur d'onde dans la plage de 420 nm à 460 nm soit supérieure à 95 %.

12. Système de source de lumière (10) selon l'une quelconque des revendications 1 à 11, comprenant en outre:
un élément de guidage de la lumière (14) disposé dans un chemin optique entre la première source de lumière d'excitation (11) et la structure de conversion de longueur d'onde (13),
dans lequel l'élément de guidage de lumière (14) comporte une zone centrale et une zone périphérique entourant la zone centrale, la zone centrale est configurée pour réfléchir la première lumière d'excitation émise par la première source de lumière d'excitation (11), de telle sorte que la première lumière d'excitation soit incidente sur la couche de matériau de conversion de longueur d'onde (131), et la zone périphérique est une zone de transmission.

13. Système de source de lumière (10) selon la revendication 12, dans lequel l'élément de guidage de lumière (14) est un film de revêtement régional, et la zone centrale est une zone dichroïque.

14. Système de source de lumière (10) selon la revendication 12 ou 13, comprenant en outre:
une lentille collectrice située entre la structure de conversion de longueur d'onde (13) et l'élément de guidage de lumière (14).

15. Appareil d'éclairage, comprenant le système de source de lumière (10) selon l'une quelconque des revendications 1 à 14.
